# EUROPÄISCHE PATENTSCHRIFT

(11) **EP 3 433 625 B1**
(45) Veröffentlichungstag und Bekanntmachung des Hinweises auf die Patenterteilung: **12.01.2022**
(21) Anmeldenummer: 17706977.0
(22) Anmeldetag: 20.02.2017
(51) Int. Cl.: G01R 31/00, G01R 31/52, B60R 16/023

(54) **VERFAHREN ZUM ERKENNEN EINES FEHLERZUSTANDS, STEUERUNGSEINRICHTUNG, BATTERIESENSOR UND BORDNETZ**
METHOD FOR DETECTING A FAULT STATE, CONTROL DEVICE, BATTERY SENSOR AND VEHICLE ON-BOARD NETWORK
PROCÉDÉ DE DÉTECTION D'UNE DÉFAILLANCE, DISPOSITIF DE COMMANDE, CAPTEUR BATTERIE ET RÉSEAU DE BORD

(30) Priorität: 24.03.2016 DE 102016204946
(43) Veröffentlichungstag der Anmeldung: 30.01.2019
(73) Patentinhaber: Continental Automotive GmbH, 30165 Hannover (DE)
(72) Erfinder: GRAF, Hans-Michael, 93049 Regensburg (DE)
(74) Vertreter: Continental Corporation
(86) Internationale Anmeldenummer: PCT/EP2017/053777
(87) Internationale Veröffentlichungsnummer: WO 2017/162383

(56) Entgegenhaltungen:
- DE-A1-102011 084 700
- DE-A1-102015 005 971
- FR-A1- 2 944 661

## Beschreibung

Die Erfindung betrifft ein Verfahren zum Erkennen eines Fehlerzustands in einem Bordnetz mittels eines Batteriesensors und einer Steuerungsvorrichtung. Die Erfindung betrifft des Weiteren eine zugehörige Steuerungsvorrichtung, einen zugehörigen Batteriesensor sowie ein zugehöriges Fahrzeugbordnetz.

In Kraftfahrzeugen mit klassischem Bordnetz steht typischerweise lediglich eine Batterie zur Verfügung, welche alle Verbraucher inklusive des Anlassers mit Energie versorgt, falls ein Generator keine Energie mehr liefert. Im Falle eines laufenden Verbrennungsmotors stehen jedoch zwei redundante elektrische Energiequellen, nämlich Batterie und Generator, zur Verfügung, da der Generator vom Verbrennungsmotor angetrieben wird. Fällt eine der Energiequellen aus, so kann die jeweils andere Quelle das Bordnetz weiterhin versorgen. Bei der Batterie kann es sich insbesondere um eine typische Autobatterie, also einen Akkumulator, handeln.

In der FR 2 944 661 A1 ist ein System zur Überwachung eines Kommunikationsnetzwerkes gezeigt, wobei an einzelnen Leitungen Spannungen gemessen werden und mit Referenzwerten verglichen werden.

Aus Gründen der Verbrauchsminimierung wurden Kraftfahrzeuge in letzter Zeit mit automatischen Stopp-Start-Systemen ausgerüstet. Diese können den Verbrennungsmotor bei sehr geringen Geschwindigkeiten des Kraftfahrzeugs oder insbesondere auch beim Stillstand ausschalten. Hierdurch entfällt der Generator als zweite, redundante Stromquelle. Sollte gleichzeitig die Batterie ausfallen, wäre ein gesicherter Neustart des Verbrennungsmotors nicht möglich. Ein solcher Ausfall kann insbesondere die Sicherheit der Fahrzeuginsassen gefährden, beispielsweise bei einem Stopp auf Bahngleisen.

Um das Risiko eines Batterieausfalls zu minimieren, werden Kraftfahrzeuge mit Stopp-Start-Systemen meistens mit Batteriesensoren, insbesondere intelligenten Batteriesensoren ausgestattet, welche eine Überwachung der Batterie und damit der Startfähigkeit des Kraftfahrzeugs ermöglichen. Sollte eine schwache Batterie erkannt werden, dann erfolgt typischerweise keine Deaktivierung des Verbrennungsmotors.

Neben dem Ausfall der Batterie als Stromquelle kann jedoch auch die Verbindung zwischen Batterie und Bordnetz abreißen. Diese Verbindung ist meist in Form einer Kabelverbindung realisiert. Minusseitig führt typischerweise ein Kabel zur Karosserie als Masse. Plusseitig führt typischerweise ein Kabel zu einer Verteilerbox. Im Falle eines Batteriesensors wird der Strom zusätzlich durch einen Messwiderstand, auch als Shunt-Widerstand bezeichnet, geführt. Diese zusätzliche Komponente erhöht das Risiko einer Unterbrechung der elektrischen Verbindung zwischen Batterie und Bordnetz.

Es ist deshalb eine Aufgabe der Erfindung, ein Verfahren vorzusehen, welches es beispielsweise ermöglicht, innerhalb eines Batteriesensors eine Unterbrechung des Strompfads zu erkennen, während ein Generator Strom liefert. Ein Fokus liegt hierbei auf einem Batteriesensor, welcher auf der Minusseite einer Batterie verbaut ist und über eine Verbindungsleitung, teilweise auch als LIN bezeichnet, mit einem Steuergerät bzw. einer Steuerungsvorrichtung verbunden ist. Insbesondere soll ein Abriss eines Messkabels detektiert werden. Es ist des Weiteren eine Aufgabe der Erfindung, eine Steuerungsvorrichtung und einen Batteriesensor jeweils zur Ausführung des erfindungsgemäßen Verfahrens vorzusehen, sowie ein Fahrzeugbordnetz mit einer solchen Steuerungsvorrichtung oder einem solchen Batteriesensor vorzusehen.

Dies wird erfindungsgemäß durch ein Verfahren nach Anspruch 1, eine Steuerungsvorrichtung nach Anspruch 13, einen Batteriesensor nach Anspruch 14 und ein Fahrzeugbordnetz nach Anspruch 15 erreicht. Vorteilhafte Ausgestaltungen können beispielsweise den jeweiligen Unteransprüchen entnommen werden. Der Inhalt der Ansprüche wird durch ausdrückliche Inbezugnahme zum Inhalt der Beschreibung gemacht.

Die Erfindung betrifft ein Verfahren zum Erkennen eines Fehlerzustands in einem Bordnetz mittels eines Batteriesensors und einer Steuerungsvorrichtung. Der Batteriesensor und die Steuerungsvorrichtung sind über zumindest eine Verbindungsleitung zur Kommunikation miteinander verbunden. Es kann also beispielsweise eine Verbindungsleitung vorhanden sein, oder es können auch zwei oder mehr Verbindungsleitungen vorhanden sein. Diese können beispielsweise als LIN-Verbindung ausgeführt sein.

Das Verfahren weist folgende Schritte auf:
- Messen einer Leitungsspannung an der Verbindungsleitung,
- Ermitteln, ob sich die Leitungsspannung innerhalb zumindest eines vorgegebenen Normalbereichs befindet, und
- Feststellen des Fehlerzustands, wenn sich die Leitungsspannung außerhalb des Normalbereichs befindet.

Das erfindungsgemäße Verfahren beruht auf der Erkenntnis, dass sich Spannungen an der Verbindungsleitung bei Normalfunktion typischerweise innerhalb eines gut abgrenzbaren und vorausberechenbaren Normalbereichs befinden, jedoch bei bestimmten Fehlfunktionen außerhalb dieses Normalbereichs liegen. Hierauf wird weiter unten näher eingegangen werden. Es sei verstanden, dass das erfindungsgemäße Verfahren insbesondere dadurch umgesetzt werden kann, dass an der Verbindungsleitung, welche normalerweise lediglich digitale Signale überträgt und es damit ausreicht, das Vorliegen einer logischen "0" von einer logischen "1" unterscheiden zu können, eine genauere Messung von Spannungswerten vorzunehmen, d.h. nicht nur zwei Zustände zu unterscheiden, sondern zumindest innerhalb eines gewissen Spannungsbereichs kontinuierlich oder quasi-kontinuierlich bezüglich der Spannungswerte zu messen. Es kann also anders ausgedrückt ein Wert der Leitungsspannung in Volt angegeben werden anstatt lediglich den digitalen Zustand angeben zu können. Dies sei typischerweise unter dem Begriff des "Messens einer Leitungsspannung" im Rahmen dieser Anmeldung verstanden. Es kann jedoch beispielsweise auch ermittelt werden, ob sich die Spannung im Normalbereich oder außerhalb oder in einem anderen Bereich befindet. Auch dies stellt eine Abwandlung zur Funktionalität dar, welche nur die logischen Pegel unterscheidet.

Der Fehlerzustand kann insbesondere einem Abriss einer Verbindung zwischen Batteriesensor und Masse entsprechen. Bei der Masse kann es sich insbesondere um eine Fahrzeugmasse handeln, welche beispielsweise durch ein Chassis des Fahrzeugs gebildet wird.

Das Verfahren kann in der Steuerungsvorrichtung durchgeführt werden, es kann jedoch auch in dem Batteriesensor durchgeführt werden.

Der Normalbereich liegt typischerweise in einem positiven Spannungsbereich. Dies bedeutet insbesondere, dass sowohl die untere wie auch die obere Grenze des Normalbereichs positive Spannungswerte sind.

Es kann gemäß einer Ausführung auch vorgesehen sein, dass der Fehlerzustand nur dann festgestellt wird, wenn die Leitungsspannung in einem Fehlerbereich liegt. Dieser Fehlerbereich liegt vorzugsweise im negativen Spannungsbereich. Dies bedeutet insbesondere, dass sowohl die untere wie auch die obere Grenze des Fehlerbereichs negative Spannungswerte sind.

Dieses Vorgehen beruht auf der Erkenntnis, dass sich Spannungswerte der Leitungsspannung typischerweise in einem bestimmten Fehlerbereich befinden, welcher fest und gut vorausberechenbar ist. Dies kann als zusätzliche Kontrolle verwendet werden, um nicht aufgrund einer anderen Fehlfunktion einen solchen Fehlerzustand zu erkennen. Die Verwendung des Fehlerbereichs kann jedoch auch als Alternative zur Verwendung des Normalbereichs angesehen werden, d.h. dass ein Fehlerzustand bereits dann erkannt wird, wenn die Leitungsspannung in dem Fehlerbereich liegt. Das Verfahren kann dabei grundsätzlich sowohl derart ausgeführt werden, dass ein Fehlerzustand dann erkannt wird, wenn die Leitungsspannung außerhalb des Normalbereichs oder innerhalb des Fehlerbereichs liegt, oder es kann auch lediglich ein Fehlerzustand dann erkannt werden, wenn die Leitungsspannung in dem Fehlerbereich liegt, ohne dass der Normalbereich überhaupt überprüft wird.

Die Leitungsspannung wird bevorzugt relativ zu einem Referenzpotential gemessen, welches vorzugsweise mittels eines als Spannungsteiler ausgebildeten Pull-up-Widerstands erzeugt wird. Dies erlaubt die Verwendung bestimmter Spannungsmesseinrichtungen, wie weiter unten näher ausgeführt werden wird.

Der Fehlerzustand kann auch basierend auf einem oder mehreren der folgenden Kriterien festgestellt werden:
- Wechselspannungsanteil einer vom Batteriesensor gemessenen Batteriespannung, wobei ein Fehlerzustand insbesondere dann festgestellt werden kann, wenn dieser Wechselspannungsanteil über einem entsprechenden Schwellenwert liegt,
- vom Batteriesensor gemessener Strom, insbesondere Batteriestrom, welcher betragsmäßig unterhalb eines Schwellenwerts ist, und welcher somit auf das Vorliegen einer Unterbrechung der Leitung hinweist,
- Vergleich der vom Batteriesensor gemessenen Batteriespannung mit einem Normalwert oder mit einem weiteren Normalbereich, wobei eine Abweichung der Batteriespannung vom Normalwert oder Normalbereich ebenfalls auf eine unterbrochene Leitung hinweisen kann.

Diese Kriterien können sowohl einzeln wie auch in beliebiger Kombination verwendet werden. Sie können auch zur Absicherung der bereits weiter oben beschriebenen Vorgehensweise verwendet werden, können alternativ jedoch beispielsweise auch separat eingesetzt werden, um einen Fehlerzustand zu ermitteln.

Ein Fehlerzustand kann auch bei Abbruch der Kommunikation zwischen Batteriesensor und Steuerungsvorrichtung festgestellt werden. Ein solcher Abbruch kann beispielsweise darauf basieren, dass der Batteriesensor nicht mehr mit elektrischer Leistung versorgt wird, was ebenfalls auf eine entsprechende Fehlfunktion hindeutet.

Gemäß einer Ausführung wird die Leitungsspannung am Batteriesensor gemessen, wobei die Leitungsspannung und eine Batteriespannung mittels Multiplexing gemessen werden. Dies ermöglicht die Verwendung einer einzigen Spannungsmesseinrichtung, beispielsweise eines Voltmeters, zum Messen sowohl der Batteriespannung wie auch der Leitungsspannung. Bei der Batteriespannung handelt es sich typischerweise um diejenige Größe, welche vom Batteriesensor normalerweise gemessen werden soll, um die Batterie zu überwachen.

Die Leitungsspannung kann insbesondere gemessen werden, während die Verbindungsleitung gegenüberliegend zu einer spannungsmessenden Einheit auf Masse geschaltet ist und an der spannungsmessenden Einheit nicht auf Masse geschaltet ist. Wird also die Leitungsspannung beispielsweise am Batteriesensor gemessen, so wird typischerweise die Verbindungsleitung am Batteriesensor nicht auf Masse geschaltet, wohingegen sie an der Steuerungsvorrichtung, also gegenüberliegend, auf Masse geschaltet ist. Dies erlaubt es, die jeweilige Masse der gegenüberliegenden Einheit zu messen, was vorteilhaft zur Erkennung des Fehlerzustands eingesetzt werden kann. Hierauf wird weiter unten weiter eingegangen werden.

Das gleiche gilt natürlich auch umgekehrt, so dass für den Fall, dass die Leitungsspannung an der Steuerungsvorrichtung gemessen wird, die Verbindungsleitung an der Steuerungsvorrichtung nicht auf Masse geschaltet wird, während sie am Batteriesensor auf Masse geschaltet wird.

Die Leitungsspannung kann insbesondere über eine Mehrzahl von Takten einer Datenübertragung mit niedrigem Pegel gemessen werden. Dies erlaubt, ähnlich zur bereits beschriebenen Ausführung, das Messen, während die Verbindungsleitung von der jeweils anderen Einheit auf Masse gezogen wird. Bei Verwendung einer Mehrzahl von Takten kann eine Mittelung bzw. eine zuverlässigere Messung erreicht werden. Hierzu kann beispielsweise auch eine Sample-and-Hold-Schaltung eingesetzt werden.

Der Fehlerzustand kann beispielsweise einem Abriss einer Verbindung zwischen Batteriesensor und Batterie entsprechen. Die Leitungsspannung kann insbesondere für diesen Fall über eine Anzahl oder Mehrzahl von Takten einer Datenübertragung mit hohem Pegel gemessen werden. Dies erlaubt das Feststellen eines Abrisses einer Verbindung zwischen Batteriesensor und Batterie, wobei darauf verwiesen sei, dass weiter oben insbesondere ein Fehlerzustand in Form eines Abrisses einer Verbindung zwischen Batteriesensor und Masse diskutiert wurde. Es sei verstanden, dass das Verfahren sowohl so ausgeführt werden kann, dass nur einer der beiden beschriebenen Fehlerzustände erkannt wird, oder es kann auch so ausgeführt werden kann, dass beide beschriebenen Fehlerzustände oder gegebenenfalls auch weitere Fehlerzustände erkannt und gegebenenfalls auch voneinander unterschieden werden können.

Es sei verstanden, dass der Batteriesensor typischerweise aus der Batterie oder aus dem Bordnetz versorgt wird. Ansonsten wird der Batteriesensor typischerweise ausfallen, sofern er nicht über eine andere Stromversorgung verfügt. Ein solcher Ausfall kann beispielsweise, wie bereits erwähnt, als Abbruch der Kommunikation zwischen Batteriesensor und Steuerungsvorrichtung erkannt werden und insbesondere auch auf einen Fehlerzustand hinweisen.

Gemäß einer bevorzugten Ausführung wird ansprechend auf das Feststellen des Fehlerzustands das Abschalten eines Verbrennungsmotors deaktiviert. Damit kann verhindert werden, dass bei einem Fehler im elektrischen Bordnetz eines Fahrzeugs auch die zweite Stromquelle, nämlich der typischerweise vom Verbrennungsmotor angetriebene Generator, deaktiviert wird und somit ein Liegenbleiben des Fahrzeugs droht, was das Fahrzeug und seine Insassen sowie andere Verkehrsteilnehmer einer erheblichen Gefährdung aussetzen würde.

Jedoch sind auch andere Maßnahmen zur Erzielung eines sicheren Fahrzeugzustands denkbar. Beispielsweise kann eine zusätzliche Batterie oder andere Stromquelle zugeschaltet werden oder es kann bei einem selbstfahrenden Fahrzeug ein Brems- oder Anhaltemanöver eingeleitet werden.

Die Erfindung betrifft des Weiteren eine Steuerungsvorrichtung, welche dazu ausgebildet ist, mit einer Batterie und vorzugsweise auch mit einer Fahrzeugchassis verbunden zu werden, welche des Weiteren dazu ausgebildet ist, über eine Verbindungsleitung mit einem Batteriesensor zur Kommunikation verbunden zu werden, und welche dazu konfiguriert ist, ein Verfahren gemäß der Erfindung durchzuführen.

Die Erfindung betrifft des Weiteren einen Batteriesensor, welcher dazu ausgebildet ist, mit einer Batterie und vorzugsweise auch mit einer Fahrzeugchassis verbunden zu werden, welche des Weiteren dazu ausgebildet ist, über eine Verbindungsleitung mit einer Steuerungsvorrichtung zur Kommunikation verbunden zu werden, und welcher dazu konfiguriert ist, ein Verfahren gemäß der Erfindung durchzuführen.

Mittels der erfindungsgemäßen Steuerungsvorrichtung bzw. des erfindungsgemäßen Batteriesensors kann das erfindungsgemäße Verfahren vorzugsweise in geeignete Komponenten implementiert werden. Dabei kann auf alle beschriebenen Ausführungen und Varianten des Verfahrens zurückgegriffen werden. Die Steuerungsvorrichtung bzw. der Batteriesensor können dabei jeweils insbesondere Prozessormittel und Speichermittel aufweisen, wobei in den Speichermitteln Programmcode gespeichert ist, bei dessen Ausführung die Prozessormittel sich in entsprechender Weise verhalten bzw. ein erfindungsgemäßes Verfahren ausführen.

Die Erfindung betrifft des Weiteren ein Fahrzeugbordnetz, welches eine Batterie, einen mit der Batterie verbundenen Batteriesensor, eine Steuerungsvorrichtung und einen Generator aufweist, wobei der Batteriesensor und die Steuerungsvorrichtung über zumindest eine Verbindungsleitung zur Kommunikation miteinander verbunden sind. Der Generator wird vorzugsweise von einem Verbrennungsmotor angetrieben. Die Batterie, der Batteriesensor und der Generator haben eine gemeinsame positive Leitung. Insbesondere haben sie auch eine gemeinsame Masse.

Dabei ist vorgesehen, dass die Steuerungsvorrichtung erfindungsgemäß ausgebildet ist oder der Batteriesensor erfindungsgemäß ausgebildet ist. Typischerweise genügt es, wenn eine dieser beiden Komponenten erfindungsgemäß ausgebildet ist. Dabei kann auf alle beschriebenen Ausführungen und Varianten zurückgegriffen werden.

Weitere Merkmale und Vorteile wird der Fachmann den nachfolgend mit Bezug auf die beigefügte Zeichnung beschriebenen Ausführungsbeispielen entnehmen. Dabei zeigen:
- Fig. 1:: ein Bordnetz in einem Normalzustand,
- Fig. 2:: ein Bordnetz in einem Fehlerzustand,
- Fig. 3:: eine typische Beschaltung,
- Fig. 4:: eine Beschaltung in einem Fehlerzustand,
- Fig. 5:: eine Prinzipdarstellung eines Fehlerzustands,
- Fig. 6:: eine alternative Beschaltung,
- Fig. 7:: eine noch weitere alternative Beschaltung.

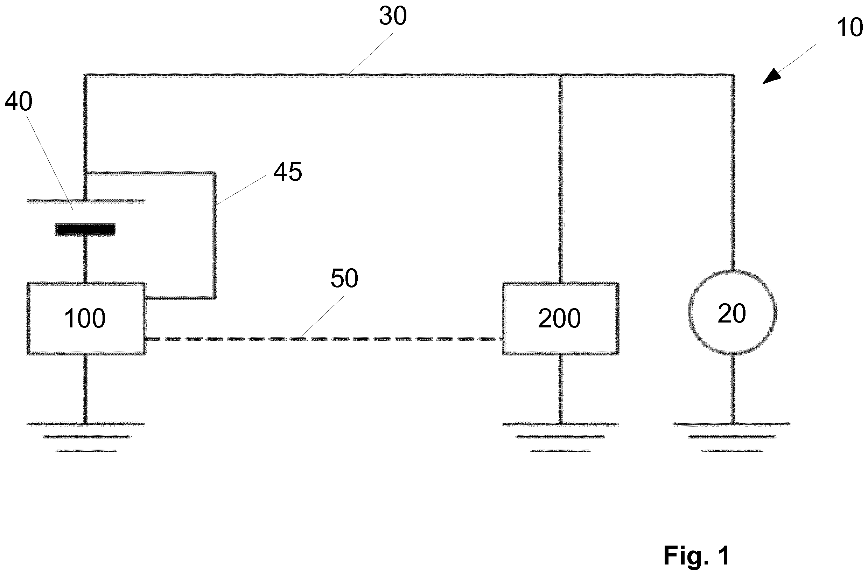

Fig. 1 zeigt schematisch ein Bordnetz 10 für ein Kraftfahrzeug. Dieses weist einen Generator 20, eine Batterie 40, einen Batteriesensor 100 und eine Steuerungsvorrichtung 200 auf. Die Batterie 40, die Steuerungsvorrichtung 200 und der Generator 20 sind über eine gemeinsame Plus-Leitung 30 miteinander verbunden. Der Batteriesensor 100 ist zwischen der Batterie 40 und Masse geschaltet. Der Generator 20 und die Steuerungsvorrichtung 200 sind ebenfalls auf Masse geschaltet. Der Batteriesensor 100 und die Steuerungsvorrichtung 200 sind über eine Verbindungsleitung 50 kommunikativ miteinander verbunden. Dabei handelt es sich typischerweise um eine Eindraht-Kommunikationsleitung. Des Weiteren ist zu erkennen, dass der Batteriesensor 100 über eine Spannungsversorgungsleitung 45 von der Batterie 40 bzw. dem Generator 20 mit der für seinen Betrieb notwendigen elektrischen Energie versorgt wird.

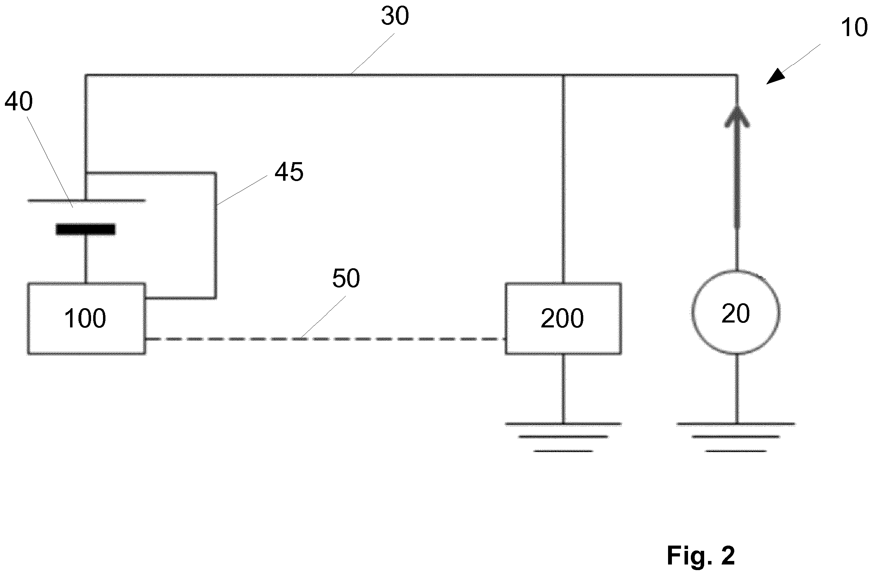

Es sei erwähnt, dass Fig. 1 einen normalen Zustand zeigt, in welchem die dargestellten Komponenten normal funktionieren und kein Fehlerzustand erkennbar ist. Fig. 2 zeigt demgegenüber das Bordnetz 10 von Fig. 1 in einem Fehlerzustand. Dabei ist die Verbindung zwischen dem Batteriesensor 100 und der Masse abgerissen. Dies kann beispielsweise durch ein Durchbrennen oder Abreißen des dafür verwendeten Kabels geschehen.

Alle Komponenten hängen plusseitig weiterhin an der Plusleitung 30. Jedoch haben der Batteriesensor 100 und die Batterie 40 keine gemeinsame Masse mehr zur Steuerungsvorrichtung 200 und zum Generator 20. Somit fließt kein Strom mehr vom Bordnetz 10 in die Batterie 40 und auch nicht aus der Batterie 40 in das Bordnetz 10. Da der Batteriestrom auf 0 fällt, stellt sich eine typische Batteriespannung von beispielsweise etwa 11,5 V bis 13 V ein, sofern beispielsweise eine typische nominale Batteriespannung von 12 V zugrunde gelegt wird. Der Generator 20 wird weiterhin auf eine Ladespannung von typischerweise 13,8 V bis 14,8 V geregelt, ein entsprechender Stromfluss ist in Figur 2 durch einen Pfeil eingezeichnet. Da die Batterie 40 auch als Filter für die Wechselstromanteile des Generators 20 entfällt, wird die Spannung im Bordnetz 10 zusätzlich von einem hohen Wechselspannungsanteil überlagert.

Die oben beschriebenen Informationen, dass der Batteriestrom 0 A beträgt und die Spannung zwischen 11,5 V und 13 V liegt, können zwar grundsätzlich einzeln oder zusammengenommen als Kriterien für einen solchen Fehlerzustand verwendet werden, sind jedoch für sich genommen typischerweise nicht ausreichend, um auf einen Masseabriss zu schließen. Derartige Messwerte können sich nämlich beispielsweise auch im Ruhezustand eines Fahrzeugs einstellen. Auf einen Masseabriss kann insbesondere in der Steuerungsvorrichtung 200 geschlossen werden, wenn die Kommunikation zum Batteriesensor 100 fehlt und/oder wenn der Batteriesensor 100 einen Strom von nahezu oder exakt 0 A liefert, und zwar insbesondere bei stabiler Spannung, während die Steuerungsvorrichtung 200 eine instabile oder deutlich zu hohe Spannung misst. Diese Kriterien können ebenfalls einzeln oder zusammen oder auch zusammen mit anderen Kriterien verwendet werden, um auf einen Masseabriss bzw. einen anderen Fehlerzustand zu schließen.

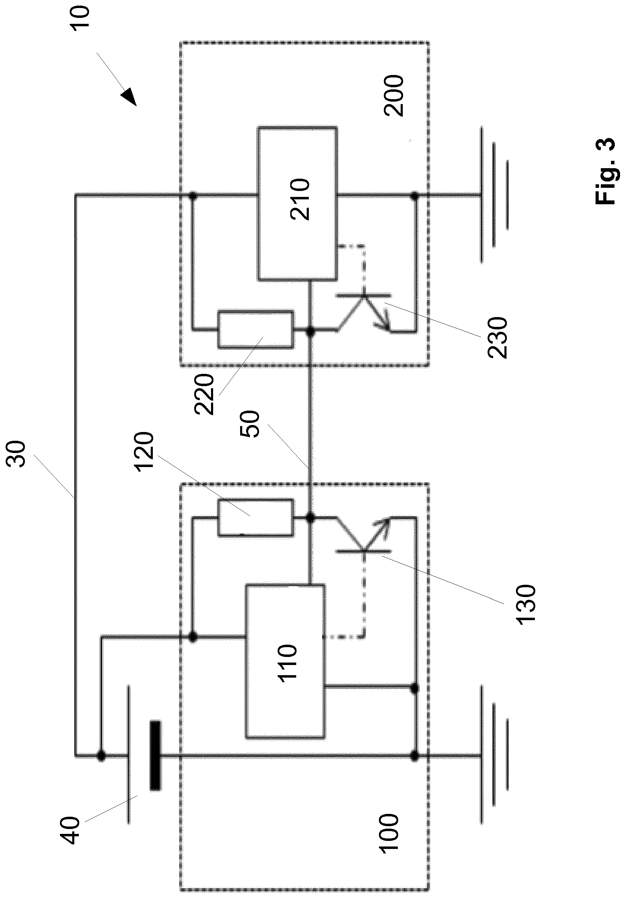

Fig. 3 zeigt, wie Eigenschaften der typischerweise eindrahtigen Verbindungsleitung 50 zur Ermittlung des Masseabrisses herangezogen werden können. Sie zeigt insbesondere die typische Beschaltung einer LIN-Verbindungsleitung.

Dabei ist auch zu erkennen, dass der Batteriesensor 100 eine Steuereinheit 110, einen Widerstand 120 und einen Transistor 130 aufweist, welche typischerweise so verschaltet sind, dass damit zwei digitale Zustände an die Verbindungsleitung 50 angelegt werden können. Bei dem Widerstand 120 handelt es sich typsicherweise um einen Pull-up-Widerstand. Ebenso weist die Steuerungsvorrichtung 200 eine Steuereinheit 210, einen Widerstand 220 und einen Transistor 230 auf, welche ebenfalls so verschaltet sind, dass in üblicher Weise zwei digitale Zustände an die Verbindungsleitung 50 angelegt werden können.

Die Verbindungsleitung 50 liegt normalerweise auf Bordnetzspannung. Durch Ansteuern der Transistoren 130, 230 in dem Batteriesensor 100 oder in der Steuerungsvorrichtung 200 kann die Spannung auf nahezu 0 V heruntergezogen werden. Bei einem beispielhaften Schalterwiderstand, also insbesondere Widerstand des jeweiligen Transistors 130, 230 von 20 Ω und einer Bordnetzspannung von 12 V ergibt sich eine rechnerische Spannung von 235 mV. Der Unterschied zwischen Bordnetzspannung (z.B. 12 V) und 235 mV wird von der jeweiligen Steuereinheit 110, 210 erkannt und als fortlaufende Einser und Nullen interpretiert.

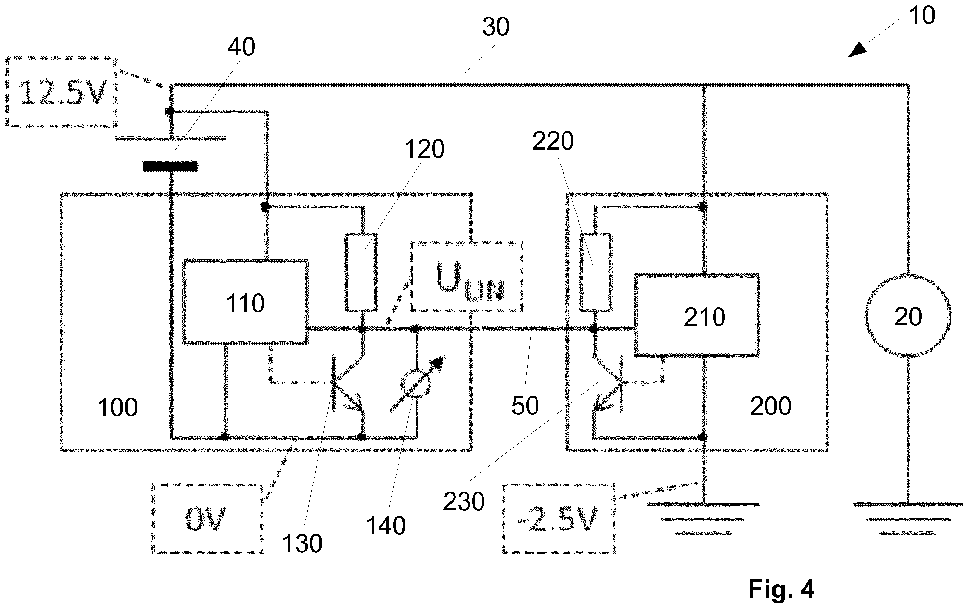

Im Falle eines Masseabrisses ergibt sich das in Fig. 4 dargestellte Szenario. Dabei ist weiterhin ein Spannungsmesser 140 im Batteriesensor 100 dargestellt, welcher die Spannung an der Verbindungsleitung 50 misst. Es sei erwähnt, dass dieser insbesondere so ausgebildet ist, dass er nicht nur eine logische Null von einer logischen Eins unterscheiden kann, sondern einen genaueren Wert der anliegenden Spannung messen kann. Hierbei handelt es sich um die eingezeichnete Spannung U_{LIN}.

Auch weitere Spannungswerte sind in Fig. 4 eingezeichnet, welche nachfolgend erläutert werden.

Die Masse des Batteriesensors 100 liegt auf Batterie-Minus und wird auf 0 V definiert. Infolge einer Batteriespannung von beispielsweise 12,5 V liegt das Bordnetz 10, also insbesondere die Plus-Leitung 30, dann auch auf 12,5 V. Liefert der Generator 20 eine Spannung von beispielsweise 15 V, dann liegt die Masse auf einer Spannung von -2,5 V.

Wäre nun der Transistor 140 im Batteriesensor 100 hochohmig, der Transistor 230 in der Steuerungsvorrichtung 200 jedoch niederohmig, und würde die Spannung auf der Verbindungsleitung 50 gemessen werden, dann ergäbe sich mit obigem Beispiel ein Wert von -2,5 V + 15 V × 20 mΩ / 1020 mΩ = -2,2 V. Gegenüber der normalerweise im Batteriesensor 100 gemessenen Spannung von etwa +0,3 V könnte dies als deutlicher Abfall erkannt werden.

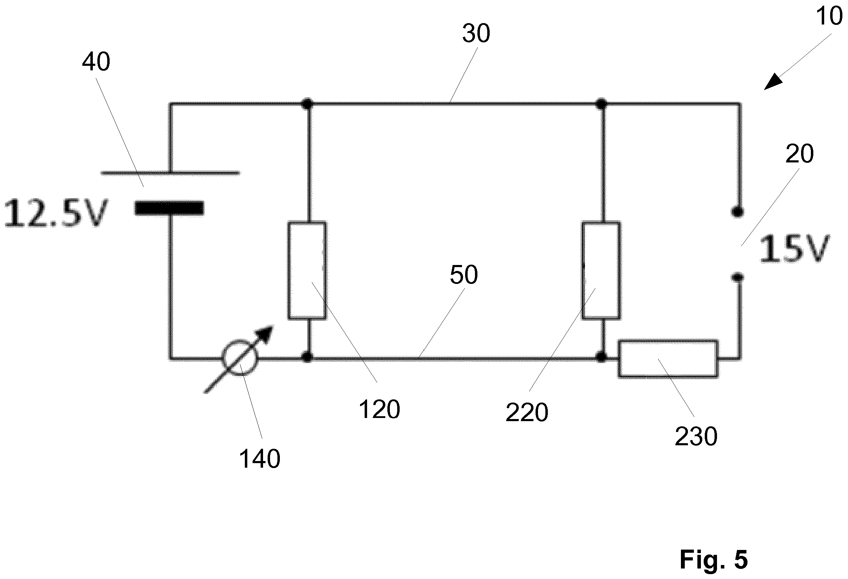

Das entsprechende Schaltbild ist in Fig. 5 gezeigt. In diesem Zusammenhang sei erwähnt, dass beispielhaft der Widerstand 120 des Batteriesensors 100 einen Widerstandswert von 30 kΩ aufweist, der Widerstand 220 der Steuerungsvorrichtung 200 einen Widerstandswert von 1 kΩ aufweist, und der Transistor 230 der Steuerungsvorrichtung 200 einen Innenwiderstand von etwa 20 Ω aufweist. Dies sind beispielhafte, typische Werte, von welchen jedoch auch abgewichen werden kann.

Wie gezeigt wurde im Vergleich zu Ausführungen gemäß dem Stand der Technik die Funktion hinzugefügt, dass die Spannung an der Verbindungsleitung 50 bzw. an einem LIN-Bus explizit gemessen und ausgewertet wird. Übliche Funktionen eines Batteriesensors 100 sind das Messen des Batteriestroms, das Messen der Batteriespannung, das Messen der Temperatur und/oder die Kommunikation über die Verbindungsleitung 50. Durch die Auswertung der Spannung der Verbindungsleitung 50 bzw. eines LIN-Busses kann auf ein Fehlen einer leitenden Verbindung zwischen Batterie 40 und Karosserie bzw. Masse geschlossen werden. Diese Information kann insbesondere von der Steuerungsvorrichtung 200 dazu genutzt werden, eine Stopp-Start-Funktion zu deaktivieren und als Folge Liegenbleiber zu vermeiden.

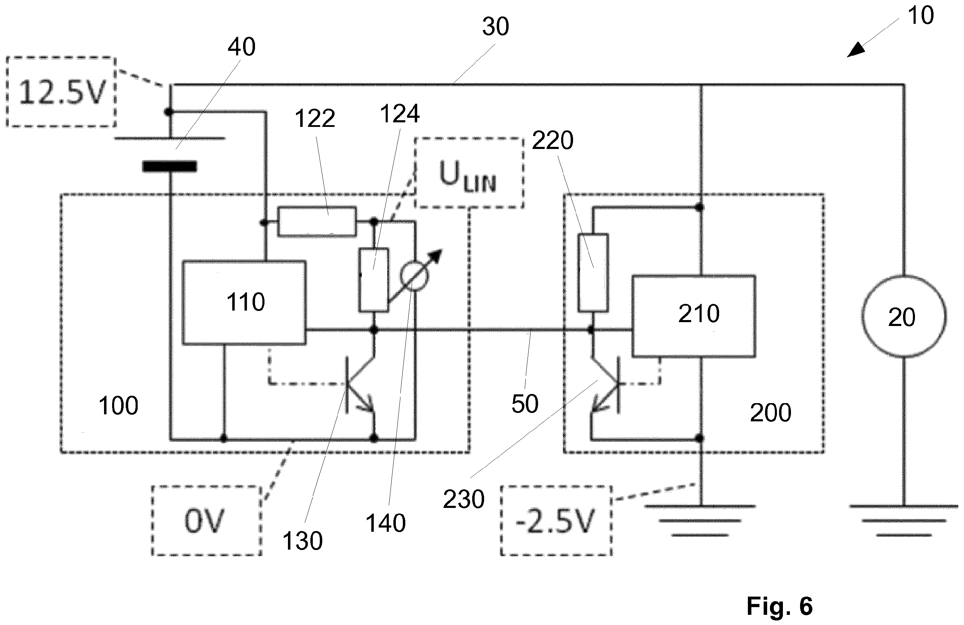

Falls die Steuereinheit 110 bzw. 210 keine negativen Spannungen erfassen kann, kann auch auf die beispielhafte Ausführung gemäß Fig. 6 zurückgegriffen werden. Dabei ist der Widerstand 120 des Batteriesensors 100, welcher insbesondere als Pull-up-Widerstand dient, durch einen Spannungsteiler ersetzt, welcher aus einem ersten Widerstand 122 und einem zweiten Widerstand 124 besteht, die zusammen einen Pull-up-Widerstand bilden. In diesem Beispiel ergäbe sich eine Messspannung U_{LIN} von 12,5 V - 28 kΩ / 30 kΩ × (12,5 V + 2,5 V) = 0 V anstelle von normalerweise 2,1 V.

Zusätzlich könnte der AC-Anteil bzw. Wechselspannungsanteil der Messspannung U_{LIN} ausgewertet werden, welcher bei einer fehlenden Batterie 40 sehr große Werte annehmen kann. Ein zusätzliches Kriterium wäre ein Messstrom von nahezu 0 A. Auch ein Vergleich der Messspannung U_{LIN} mit der im Batteriesensor 100 normalerweise gemessenen Batteriespannung kann verwendet werden. Es sei verstanden, dass grundsätzlich alle Kriterien, welche hierin offenbart sind, sowohl einzeln wie auch in beliebiger Kombination und mit beliebigen logischen Verknüpfungen angewendet werden können.

Der Spannungsmesser 140 des Batteriesensors 100 kann beispielsweise auch zur Messung der Batteriespannung der Batterie 40 verwendet werden. Dies kann beispielsweise durch Multiplexing erfolgen. Auch ein Messkanal zur Messung des Batteriestroms könnte zur Bestimmung von U_{LIN} herangezogen werden.

Sinnvoll ist insbesondere eine Auswertung von Minimalspannungen, also wenn die Steuerungsvorrichtung 200 die Spannung der Verbindungsleitung 50 auf Masse zieht. Dies kann beispielsweise einer logischen Null entsprechen. Eine Auswertung wird typischerweise nur dann vorgenommen, wenn die Steuereinheit 110 des Batteriesensors 100 den Transistor 130 nicht niederohmig geschaltet hat.

Mit einer beispielhaften, typischen Hardware eines Batteriesensors 100 kann eine Spannung der Verbindungsleitung 50 beispielsweise zeitlich auf 0,1 ms bis 2 ms aufgelöst werden. Die übliche Übertragungsrate kann jedoch beispielsweise 19,2 Kilobyte betragen, was 0,052 ms pro Bit entspricht. Dies bedeutet, dass die jeweils andere Einheit, im vorliegenden Beispiel also insbesondere die Steuerungsvorrichtung 200, vorteilhaft beispielsweise 2 bis 4 Bits (ein Frame beinhaltet 64 Bits) mit niedriger Spannung sendet, um die Minimalspannung direkt messen zu können.

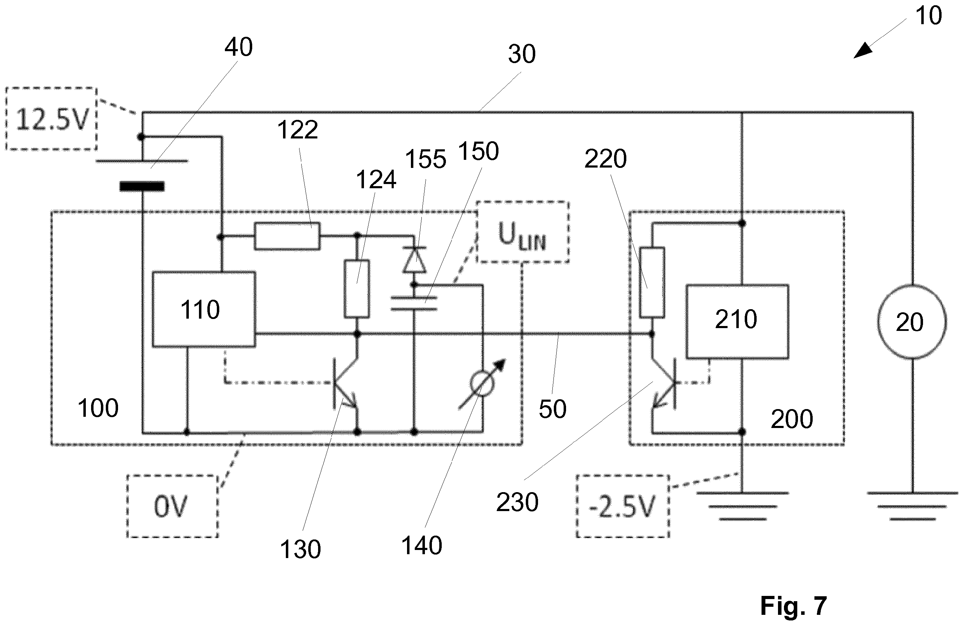

Alternativ zur direkten Messung der Spannung der Verbindungsleitung 50 mittels eines Analog-Digital-Konverters kann auch eine Hardware-Lösung vorgesehen werden, welche die Minimalspannung in einem Kondensator zwischenspeichert, was beispielsweise durch eine Sample-and-Hold-Schaltung realisiert werden kann. Eine solche Ausführung ist beispielhaft in Fig. 7 dargestellt. Hierzu sind ein Kondensator 150 und eine damit verschaltete Diode 155 im Batteriesensor 100 angeordnet.

Auch in einem Batteriesensor 100 mit pulsseitiger Strommessung wäre die beschriebene Funktionalität grundsätzlich realisierbar. Vorteilhaft ist insbesondere
- eine leitende elektrische Verbindung zum Bordnetz 10,
- eine leitende elektrische Verbindung zum Minuspol der Batterie 40,
- eine leitende elektrische Verbindung (zum Beispiel LIN), welche zumindest zeitweise eine der Karosserie nahe Spannung aufweist.

Es wäre auch eine Lösung in der Steuerungsvorrichtung 200 anstelle einer Umsetzung innerhalb des Batteriesensors 100 denkbar. Hierzu sollte der Batteriesensor 100 beispielsweise Informationen über
- die absolute Batteriespannung,
- den Wechselstromanteil bzw. Wechselspannungsanteil der Batteriespannung, und
- die Information, dass der Batteriestrom bei etwa 0 A liegt,
erfassen und vorteilhaft an die Steuerungsvorrichtung 200 übertragen.

Durch Messung der Spannung in der Steuerungsvorrichtung 200 und Vergleich mit den Werten vom Batteriesensor 100 kann ebenfalls auf einen Masseabfall der Batterie 40 geschlossen werden.

Vorteilhaft an einer Ausführung im Batteriesensor 100 ist, dass das Problem vermieden wird, dass bei Abreißen der Masseverbindung auch die Gefahr droht, dass die Kommunikation auf der Verbindungsleitung 50 nicht mehr sicher funktioniert. Wenn die Kommunikation nicht mehr sicher funktioniert, ist typischerweise auch die Übertragung des detektierten Fehlers nicht mehr möglich.

Vorteilhaft ist zur Detektion eines Masseabrisses einer Batterie 40 eine weitere Stromquelle, insbesondere der Generator 20, zur Versorgung des Bordnetzes vorhanden. Der Generator 20 wird typischerweise durch einen Verbrennungsmotor angetrieben.

Es sei erwähnt, dass auch das Erkennen des Abrisses eines positiven Batteriekabels möglich ist, und zwar insbesondere über eine entsprechende Ausgestaltung. In diesem Fall wird vorteilhaft nicht die Minimalspannung, sondern die Maximalspannung analysiert.

Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden. Es können jedoch grundsätzlich auch weitere Schritte ausgeführt werden, auch solche welche nicht erwähnt sind.

## Patentansprüche

1. Verfahren zum Erkennen eines Fehlerzustands in einem Bordnetz (10) mittels eines Batteriesensors (100) und einer Steuerungsvorrichtung (200),
- wobei der Batteriesensor (100) und die Steuerungsvorrichtung (200) über zumindest eine Verbindungsleitung (50) zur Kommunikation miteinander verbunden sind,
wobei das Verfahren folgende Schritte aufweist:
- Messen einer Leitungsspannung an der Verbindungsleitung (50),
- Ermitteln, ob sich die Leitungsspannung innerhalb zumindest eines vorgegebenen Normalbereichs befindet, und
- Feststellen des Fehlerzustands, wenn sich die Leitungsspannung außerhalb des Normalbereichs befindet.

2. Verfahren nach Anspruch 1,
- wobei der Fehlerzustand einem Abriss einer Verbindung zwischen Batteriesensor (100) und Masse, insbesondere Fahrzeugmasse, entspricht.

3. Verfahren nach einem der vorhergehenden Ansprüche,
- welches in der Steuerungsvorrichtung (200) durchgeführt wird;
oder
- welches in dem Batteriesensor (100) durchgeführt wird.

4. Verfahren nach einem der vorhergehenden Ansprüche,
- wobei der Normalbereich im positiven Spannungsbereich liegt.

5. Verfahren nach einem der vorhergehenden Ansprüche,
- wobei der Fehlerzustand nur dann festgestellt wird, wenn die Leitungsspannung in einem Fehlerbereich liegt,
- wobei der Fehlerbereich vorzugsweise im negativen Spannungsbereich liegt.

6. Verfahren nach einem der vorhergehenden Ansprüche,
- wobei die Leitungsspannung relativ zu einem Referenzpotential gemessen wird, welches vorzugsweise mittels eines als Spannungsteiler ausgebildeten Pull-up-Widerstands (122, 124) erzeugt wird.

7. Verfahren nach einem der vorhergehenden Ansprüche,
- wobei der Fehlerzustand auch basierend auf einem oder mehreren der folgenden Kriterien festgestellt wird:
- Wechselspannungsanteil einer vom Batteriesensor (100) gemessenen Batteriespannung,
- vom Batteriesensor (100) gemessener Strom, insbesondere Batteriestrom, welche betragsmäßig unterhalb eines Schwellenwerts ist,
- Vergleich der vom Batteriesensor (100) gemessenen Batteriespannung mit einem Normalwert oder mit einem weiteren Normalbereich.

8. Verfahren nach einem der vorhergehenden Ansprüche,
- wobei der Fehlerzustand auch bei Abbruch der Kommunikation zwischen Batteriesensor (100) und Steuerungsvorrichtung (200) festgestellt wird.

9. Verfahren nach einem der vorhergehenden Ansprüche,
- wobei die Leitungsspannung gemessen wird, während die Verbindungsleitung (50) gegenüberliegend zu einer spannungsmessenden Einheit auf Masse geschaltet ist und an der spannungsmessenden Einheit nicht auf Masse geschaltet ist.

10. Verfahren nach einem der vorhergehenden Ansprüche,
- wobei die Leitungsspannung über eine Anzahl oder Mehrzahl von Takten einer Datenübertragung mit niedrigem Pegel gemessen wird.

11. Verfahren nach einem der vorhergehenden Ansprüche,
- wobei der Fehlerzustand einem Abriss einer Verbindung zwischen Batteriesensor (100) und Batterie (40) entspricht, und
- wobei die Leitungsspannung über eine Anzahl oder Mehrzahl von Takten einer Datenübertragung mit hohem Pegel gemessen wird.

12. Verfahren nach einem der vorhergehenden Ansprüche,
- wobei ansprechend auf das Feststellen des Fehlerzustands das Abschalten eines Verbrennungsmotors deaktiviert wird.

13. Steuerungsvorrichtung (200), welche dazu ausgebildet ist, mit einer Batterie (40) und vorzugsweise auch mit einer Fahrzeugchassis verbunden zu werden, welche dazu ausgebildet ist, über eine Verbindungsleitung (50) mit einem Batteriesensor (100) zur Kommunikation verbunden zu werden, und welche dazu konfiguriert ist, ein Verfahren nach einem der vorhergehenden Ansprüche durchzuführen.

14. Batteriesensor (100), welcher dazu ausgebildet ist, mit einer Batterie (40) und vorzugsweise auch mit einer Fahrzeugchassis verbunden zu werden, welche dazu ausgebildet ist, über eine Verbindungsleitung (50) mit einer Steuerungsvorrichtung (200) zur Kommunikation verbunden zu werden, und welcher dazu konfiguriert ist, ein Verfahren nach einem der Ansprüche 1 bis 12 durchzuführen.

15. Fahrzeugbordnetz (10), aufweisend,
- eine Batterie (40),
- einen mit der Batterie (40) verbundenen Batteriesensor (100),
- eine Steuerungsvorrichtung (200), und
- einen Generator (20), welcher vorzugsweise von einem Verbrennungsmotor angetrieben wird,
- wobei die Batterie (40), der Batteriesensor (100) und der Generator (20) eine gemeinsame positive Leitung (30) haben und eine gemeinsame Masse haben,
- wobei der Batteriesensor (100) und die Steuerungsvorrichtung (200) über zumindest eine Verbindungsleitung (50) zur Kommunikation miteinander verbunden sind, und
- wobei die Steuerungsvorrichtung (200) gemäß Anspruch 13 ausgebildet ist oder der Batteriesensor (100) nach Anspruch 14 ausgebildet ist.

## Claims

1. Method for detecting a fault state in a vehicle electrical system (10) by means of a battery sensor (100) and a control apparatus (200),
- wherein the battery sensor (100) and the control apparatus (200) are connected to one another via at least one connection line (50) for the purpose of communication,
wherein the method comprises the following steps:
- measuring a line voltage on the connection line (50),
- determining whether the line voltage is within at least a predefined normal range, and
- determining the fault state if the line voltage is outside the normal range.

2. Method according to Claim 1,
- wherein the fault state corresponds to a loss of a connection between the battery sensor (100) and earth, in particular vehicle earth.

3. Method according to one of the preceding claims,
- which is carried out in the control apparatus (200); or
- which is carried out in the battery sensor (100).

4. Method according to one of the preceding claims,
- wherein the normal range is in the positive voltage range.

5. Method according to one of the preceding claims,
- wherein the fault state is determined only when the line voltage is in a fault range,
- wherein the fault range is preferably in the negative voltage range.

6. Method according to one of the preceding claims,
- wherein the line voltage is measured relative to a reference potential which is preferably generated by means of a pull-up resistor (122, 124) in the form of a voltage divider.

7. Method according to one of the preceding claims,
- wherein the fault state is also determined on the basis of one or more of the following criteria:
- AC voltage component of a battery voltage measured by the battery sensor (100),
- current measured by the battery sensor (100), in particular battery current, which is below a threshold value in terms of absolute value,
- comparison of the battery voltage measured by the battery sensor (100) with a normal value or with a further normal range.

8. Method according to one of the preceding claims,
- wherein the fault state is determined even if the communication between the battery sensor (100) and the control apparatus (200) is terminated.

9. Method according to one of the preceding claims,
- wherein the line voltage is measured while the connection line (50) is connected to earth opposite a voltage-measuring unit and is not connected to earth at the voltage-measuring unit.

10. Method according to one of the preceding claims,
- wherein the line voltage is measured with a low level over a number or a plurality of data transmission cycles.

11. Method according to one of the preceding claims,
- wherein the fault state corresponds to a loss of a connection between the battery sensor (100) and the battery (40), and
- wherein the line voltage is measured with a high level over a number or a plurality of data transmission cycles.

12. Method according to one of the preceding claims,
- wherein the disconnection of an internal combustion engine is deactivated in response to the determination of the fault state.

13. Control apparatus (200) which is designed to be connected to a battery (40) and preferably also to a vehicle chassis, which is designed to be connected to a battery sensor (100) via a connection line (50) for the purpose of communication, and is configured to carry out a method according to one of the preceding claims.

14. Battery sensor (100) which is designed to be connected to a battery (40) and preferably also to a vehicle chassis, which is designed to be connected to a control apparatus (200) via a connection line (50) for the purpose of communication, and is configured to carry out a method according to one of Claims 1 to 12.

15. Vehicle electrical system (10) having
- a battery (40),
- a battery sensor (100) which is connected to the battery (40),
- a control apparatus (200), and
- a generator (20) which is preferably driven by an internal combustion engine,
- wherein the battery (40), the battery sensor (100) and the generator (20) have a common positive line (30) and a common earth
- wherein the battery sensor (100) and the control apparatus (200) are connected to one another via at least one connection line (50) for the purpose of communication, and
- wherein the control apparatus (200) is designed according to Claim 13 or the battery sensor (100) is designed according to Claim 14.

## Revendications

1. Procédé permettant de reconnaître un état de défaut dans un réseau de bord (10) au moyen d'un capteur de batterie (100) et d'un dispositif de commande (200),
- le capteur de batterie (100) et le dispositif de commande (200) étant reliés l'un à l'autre par au moins une ligne de liaison (50) pour la communication,
le procédé présentant les étapes suivantes consistant à :
- mesurer une tension de ligne sur la ligne de liaison (50),
- déterminer si la tension de ligne se trouve à l'intérieur d'au moins une plage normale prédéfinie, et
- constater l'état de défaut si la tension de ligne se trouve en dehors de la plage normale.

2. Procédé selon la revendication 1,
- l'état de défaut correspondant à une rupture d'une liaison entre le capteur de batterie (100) et la masse, en particulier la masse du véhicule.

3. Procédé selon l'une quelconque des revendications précédentes,
- qui est effectué dans le dispositif de commande (200) ; ou
- qui est effectué dans le capteur de batterie (100) .

4. Procédé selon l'une quelconque des revendications précédentes,
- la plage normale se trouvant dans la plage de tension positive.

5. Procédé selon l'une quelconque des revendications précédentes,
- l'état de défaut n'étant constaté que si la tension de ligne se trouve dans une plage de défaut,
- la plage de défaut se trouvant de préférence dans la plage de tension négative.

6. Procédé selon l'une quelconque des revendications précédentes,
- la tension de ligne étant mesurée par rapport à un potentiel de référence qui est généré de préférence au moyen d'une résistance de rappel (122, 124) réalisée sous la forme d'un diviseur de tension.

7. Procédé selon l'une quelconque des revendications précédentes,
- l'état de défaut étant également constaté sur la base d'un ou de plusieurs des critères suivants :
- la part de tension alternative d'une tension de batterie mesurée par le capteur de batterie (100),
- le courant mesuré par le capteur de batterie (100), en particulier le courant de batterie, qui présente une grandeur inférieure à une valeur seuil,
- la comparaison de la tension de batterie mesurée par le capteur de batterie (100) avec une valeur normale ou avec une autre plage normale.

8. Procédé selon l'une quelconque des revendications précédentes,
- l'état de défaut étant également constaté en cas de coupure de la communication entre le capteur de batterie (100) et le dispositif de commande (200).

9. Procédé selon l'une quelconque des revendications précédentes,
- la tension de ligne étant mesurée pendant que la ligne de liaison (50) est connectée à la masse à l'opposé d'une unité de mesure de tension et n'est connectée à la masse au niveau de l'unité de mesure de tension.

10. Procédé selon l'une quelconque des revendications précédentes,
- la tension de ligne étant mesurée pendant un certain nombre ou une pluralité de cycles d'une transmission de données ayant un niveau bas.

11. Procédé selon l'une quelconque des revendications précédentes,
- l'état de défaut correspondant à une rupture d'une liaison entre le capteur de batterie (100) et la batterie (40), et
- la tension de ligne étant mesurée pendant un certain nombre ou une pluralité de cycles d'une transmission de données ayant un niveau haut.

12. Procédé selon l'une quelconque des revendications précédentes,
- dans lequel, en réaction à la constatation de l'état de défaut, l'arrêt d'un moteur à combustion est désactivé.

13. Dispositif de commande (200) qui est réalisé pour être relié à une batterie (40) et de préférence également à un châssis de véhicule, qui est réalisé pour être relié par une ligne de liaison (50) à un capteur de batterie (100) pour la communication, et qui est configuré pour effectuer un procédé selon l'une quelconque des revendications précédentes.

14. Capteur de batterie (100) qui est réalisé pour être relié à une batterie (40) et de préférence également à un châssis de véhicule, qui est réalisé pour être relié par une ligne de liaison (50) à un dispositif de commande (200) pour la communication, et qui est configuré pour effectuer un procédé selon l'une quelconque des revendications 1 à 12.

15. Réseau de bord de véhicule (10), présentant
- une batterie (40),
- un capteur de batterie (100) relié à la batterie (40),
- un dispositif de commande (200), et
- un générateur (20) qui est entraîné de préférence par un moteur à combustion,
- la batterie (40), le capteur de batterie (100) et le générateur (20) ayant une ligne positive commune (30) et une masse commune,
- le capteur de batterie (100) et le dispositif de commande (200) étant reliés l'un à l'autre par au moins une ligne de liaison (50) pour la communication, et
- le dispositif de commande (200) étant réalisé selon la revendication 13, ou le capteur de batterie (100) étant réalisé selon la revendication 14.
